# EUROPEAN PATENT APPLICATION

(11) **EP 1 862 560 A1**
(43) Date of publication of application: **05.12.2007**
(21) Application number: 06715106.8
(22) Date of filing: 02.03.2006
(51) Int. Cl.: C22C 9/02, C22F 1/08, H01L 23/48, C22F 1/00

(54) **COPPER ALLOY AND METHOD FOR PRODUCTION THEREOF**

(30) Priority: 02.03.2005 JP 2005056765
(71) Applicant: The Furukawa Electric Co., Ltd., Chiyoda-ku Tokyo 100-8322 (JP)
(72) Inventor: KANEKO, Hiroshi, hi 2-chome, Chiyoda-ku Tokyo, 1008322 (JP); MIHARA, Kuniteru, hi 2-chome, Chiyoda-ku Tokyo, 1008322 (JP); EGUCHI, Tatsuhiko, hi 2-chome, Chiyoda-ku Tokyo, 1008322 (JP)
(74) Representative: Forstmeyer, Dietmar
(86) International application number: PCT/JP2006/303997
(87) International publication number: WO 2006/093233

(57) **Abstract**

A copper alloy, having Sn 3.0 to 13.0 mass%, with the balance being Cu and unavoidable impurities, which copper alloy contains crystal grains whose diameter is 1.0 to 2.0 µm, and wherein the copper alloy has a precipitate X having a diameter of 1 to 50 nm and a density of 10⁶ to 10¹⁰ per mm², and a precipitate Y having a diameter of 50 to 500 nm and a density of 10⁴ to 10⁸ per mm²; and a method of producing the copper alloy, including the steps of: cold-working the recrystallized structure with an average crystal grain diameter of 1 to 15 µm at a working ratio of 40 to 70%; and heating the resultant to obtain a recrystallized structure with a crystal grain diameter of 1 to 2 µm.

## Description

### TECHNICAL FIELD

The present invention relates to a copper alloy for electronic and electric instruments having excellent bending property and mechanical strength favorable for use in a connector or terminal which is usable in electronic and electric instruments or wirings in automobiles; and the present invention also relates to a method of producing the same.

### BACKGROUND ART

In recent years, demands for downsizing and weight saving of electronic and electric instruments and wirings in automobiles and demands for high-density packaging are increasing. When the downsizing of electric and electronic instruments and wirings in automobiles progresses, a contact area of a contact portion decreases and a sheet thickness used therein also becomes thin. Thus, in order to maintain reliability equivalent to that of the conventional ones, higher strength material becomes necessary. There are strong demands for materials used for electronic components, such as a connector or a terminal, to have high strength and excellent bending property. In order to increase mechanical strength of metal materials, not only a work hardening process but also a strengthening method of refining the crystal grain diameter of copper and copper alloy, in which a compound is precipitated or recrystallized, has been heretofore employed. This method can impart both favorable mechanical strength and excellent bending property because the method can increase mechanical strength without deteriorating toughness better than when the work hardening process is employed.

There is a technique for improving bending property by refining crystal grains using grains including a precipitate or crystallized product as a main component and having a diameter of 0.1 µm or more (e.g., see WO 02/053790 pamphlet). Further, proposed is a technique for improving a stress relaxation property by forming phosphide in a matrix (e.g., see JP-A-10-140269 ("JP-A" means unexamined published Japanese patent application)).

However, high mechanical strength, bending property, and stress relaxation resistance are required at high levels as downsizing of a connector, etc., progresses, and the above-mentioned techniques do not satisfy all of those.

### DISCLOSURE OF INVENTION

The inventors of the present invention found a composition of an alloy and a method of producing the alloy which can substantially satisfy the above-mentioned demands, by specifying a precipitate X and a precipitate Y which has a function of refining crystal grains.
According to the present invention, there is provided the following means:
(1) A copper alloy, comprising Sn 3.0 to 13.0 mass%, with the balance being Cu and unavoidable impurities, which copper alloy contains crystal grains whose diameter is 1.0 to 2.0 µm,
   wherein the copper alloy has a precipitate X having a diameter of 1 to 50 nm and a density of 10⁶ to 10¹⁰ per mm², and a precipitate Y having a diameter of 50 to 500 nm and a density of 10⁴ to 10⁸ per mm²;
(2) The copper alloy according to item (1), wherein the precipitates X and Y each are composed of P and at least one element among Mn, Mg, Cr, W, Co, B, Ni, Fe, Ca, Si, Cu, Ti, Zr, and AI;
(3) The copper alloy according to item (1), wherein the precipitates X and Y each are composed of at least two elements among Mn, Mg, Cr, W, Co, B, Ni, Fe, Ca, Si, Cu, Ti, Zr, and Al;
(4) The copper alloy according to item (1), wherein the precipitates X and Y each are composed of Fe, Ni, and P;
(5) An electronic and electric instrument part, comprising the copper alloy according to any one of the items (1) to (4); and
(6) A method of producing the copper alloy according to any one of the items

(1) to (4), wherein the method comprises the steps of:
   cold-working a recrystallized structure with an average crystal grain diameter of 1 to 15 µm at a working ratio of 40 to 70%; and
   heating the resultant to obtain a recrystallized structure with a crystal grain diameter of 1 to 2 µm.

The copper alloy of the present invention is excellent in mechanical strength, bending property, stress relaxation resistance, and the like. Therefore, the copper alloy of the present invention can preferably cope with downsizing and enhancement of performance of electronic and electric instrument components (parts). The copper alloy of the present invention is preferable as a material to be used in terminals, connectors and switches, as well as it is preferable as general-purpose conductive materials, for example, for lead frame and relays. Accordingly, the copper alloy of the present invention exhibits industrially excellent effects.
Other and further features and advantages of the invention will appear more fully from the following description, taken in connection with the accompanying drawings.

### BRIEF DESCRIPTION OF DRAWINGS

[Fig. 1]

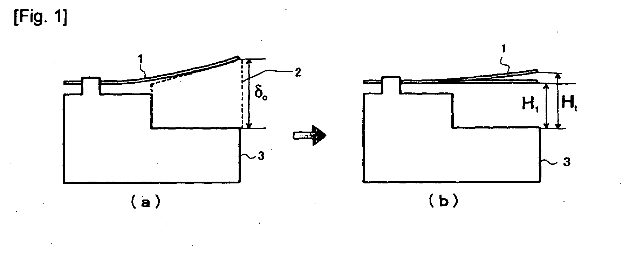

Fig. 1 is a schematic explanatory view illustrating a test method of stress relaxation property.

### BEST MODE FOR CARRYING OUT THE INVENTION

Hereinafter, preferable embodiments of the present invention are described.
The copper alloy of the present invention includes Sn, P, other addition elements, and the balance including Cu and unavoidable impurities.
In the copper alloy of the present invention, the reason for specifying the content of Sn to 3.0 to 13.0 mass% is that the mechanical strength can be improved. When the Sn content is less than 3.0 mass%, the mechanical strength obtained by solution strengthening is not sufficient. In contrast, when the Sn content exceeds 13.0 mass%, an extremely brittle Cu-Sn intermetallic compound is formed to thereby deteriorate the workability. The content of Sn is preferably 5.0 to 13.0 mass%, and more preferably 7.0 to 11.0 mass%.

The reason for specifying the crystal grain diameter of the copper alloy to 1.0 to 2.0 µm is that excellent mechanical strength and excellent bending property can be attained. When the diameter is less than 1 µm, degradation of ductility is more remarkable than improvement in mechanical strength, resulting in the deterioration in the toughness; thus workability is deteriorated. Further, there is a problem that such a copper alloy cannot be stably manufactured industrially. When the diameter exceeds 2 µm, the mechanical strength attained by refining crystal grains is insufficient. The diameter is preferably 1.0 to 1.8 µm, and more preferably 1.0 to 1.5 µm.

In the present invention, the copper alloy has a precipitate including at least two elements among Mn, Mg, Cr, W, Co, B, Ni, Fe, Ca, Si, Cu, Ti, Zr, Al, etc., or a precipitate including P and at least one element selected from the above elements.
In this specification, these precipitates are individually defined as precipitate X, which has an extremely fine nanometer size, and precipitate Y, which has a nanometer size but is larger than the precipitate X. The diameter and density of the precipitates are measured on a photograph taken with a transmission electron microscope.

The reason for specifying the diameter of the precipitate X in the copper alloy to 1 to 50 nm is to improve the stress relaxation resistance. When the diameter is lower than 1 nm or exceeds 50 nm, displacement movement cannot be prevented, and therefore the effect of improving the stress relaxation resistance cannot be achieved. The diameter is preferably 5 to 45 nm, and more preferably 10 to 40 nm.

The reason for specifying the density of the precipitate X to 10⁶ to 10¹⁰ particles/mm² is to improve the stress relaxation resistance. Such an effect cannot be sufficiently achieved when the density is lower than 10⁶ particles/mm². In order to acquire a high density precipitate whose density exceeds 10¹⁰ particles/mm², it is necessary to increase the amount of addition elements forming the precipitate. However, this is not desirable because the viscosity at the time of solidification lowers to thereby deteriorate the ingot quality. The density is preferably 10⁷ to 10¹⁰ particles/mm², and more preferably 10⁸ to 10¹⁰ particles/mm².

Further, the reason for specifying the diameter of the precipitate Y in the copper alloy to 50 to 500 nm is to stably manufacture crystal grains with the above-mentioned diameter industrially. When the diameter is less than 50 nm, it is impossible to inhibit the growth of crystal grains, resulting in the formation of coarse crystal grains. When the diameter exceeds 500 nm, the stress concentration during working occurs and from the stress concentrated portion cracks starts to be formed, resulting in a problem of working crack. The diameter is preferably 50 to 200 nm, and more preferably 75 to 150 nm.

The reason for specifying the density of the precipitate Y to 10⁴ to 10⁸ particles/mm² is that the above-mentioned crystal grains can be stably manufactured. When the density is less than 10⁴ particles/mm², it is impossible to inhibit the growth of crystal grains, resulting in the formation of coarse crystal grains. When the density exceeds 10⁸ particles/mm², the diameter of the precipitate diminishes. Therefore, it is impossible to inhibit the growth of crystal grains, resulting in the formation of coarse crystal grains. The density is preferably 10⁵ to 10⁸ particles/mm², and more preferably 10⁶ to 10⁸ particles/mm².

When the above-mentioned precipitates include P and at least one element among Mn, Mg, Cr, W, Co, B, Ni, Fe, Ca, Si, Cu, Ti, Zr, and Al, the stress relaxation resistance is improved, and thus the above-mentioned crystal grains can be stably manufactured. It is preferable to adjust the content of each of Mn, Mg, Cr, W, Co, B, Ni, Fe, Ca, Si, Cu, Ti, Zr, and Al to be in the range of 0.01 to 0.5 mass% and the total content thereof to be in the range of 0.01 to 2.0 mass%; and adjust the P content to be in the range of 0.01 to 1.0 mass%.

When the above-mentioned precipitates include at least two elements among Mn, Mg, Cr, W, Co, B, Ni, Fe, Ca, Si, Cu, Ti, Zr, and Al, the above-mentioned crystal grains can be stably manufactured. It is preferable to adjust the content of each of Mn, Mg, Cr, W, Co, B, Ni, Fe, Ca, Si, Cu, Ti, Zr, and Al to be in the range of 0.01 to 0.5 mass% and the total content thereof to be in the range of 0.01 to 2.0 mass%.

Further, when the above-mentioned precipitates are compounds including Fe, Ni, and P, the above-mentioned crystal grains can be stably manufactured, and thus such a precipitate is more desirable.

According to the method of manufacturing the copper alloy of the present invention, when a heat treatment is performed after a recrystallized structure with an average crystal grain diameter of 1 to 15 µm is subjected to a cold-working at a working ratio of 40 to 70%, a recrystallized structure whose crystal grain diameter is 1 to 2 µm can be more stably manufactured industrially. Further, it is possible to prevent variations in the working structures and particle diameters in the recrystallized structure to be obtained. When the working ratio is less than 40%, driving force at the time of recrystallizing is excessively small, and therefore it is impossible to obtain crystal grains with a diameter of 2 µm or less. When the working ratio exceeds 70%, the growth of crystal grains is accelerated, which lowers the manufacturing stability, and thus such working ratio is not preferable. Further, a cold-working at a working ratio of 70% or higher may result in a working crack on the surface, and thus such a working ratio is not preferable. The working ratio is preferably 50 to 65%, and more preferably 55 to 60%.
Further, when the crystal grain diameter in the recrystallized structure before the cold-rolling is less than 1 µm, the ductility is poor and a working crack occurs. When the crystal grain diameter in the recrystallized structure before the cold-rolling exceeds 15 µm, the working condition becomes non-uniform in the next cold-rolling. As a result, when obtaining an intended 1 to 2 µm recrystallized structure, variation in crystal grain diameters and residual working structure are caused and the bending property is deteriorated. The crystal grain diameter is preferably 2 to 10µm, and more preferably 4 to 8µm.

An example of a preferred embodiment of the method of manufacturing the copper alloy of the present invention includes the following steps: an alloy including Sn, P, other addition elements, and the balance of Cu is melted in a high-frequency melting furnace, etc., to obtain an ingot; the ingot is subjected to a homogenizing heat treatment, and is slowly cooled, followed by scalping; the resultant is subjected to a cold-rolling, and is subjected to a heat treatment d at 550 to 750°C for 1 to 10 hours in an inert gas atmosphere, followed by slow cooling; and the resultant is subjected to a cold-rolling at a rolling working ratio of 40% or higher, and is subjected to a heat treatment c at 350 to 550°C for 1 to 10 hours in an inert gas atmosphere, to obtain a structure with an average crystal grain diameter of 5 to 20 µm.

By performing the above-mentioned heat treatments c and d, the precipitates X and Y are precipitated in such a manner that they are uniformly distributed. The coarse precipitate Y is precipitated mainly in the heat treatment d, and the fine precipitate X is precipitated mainly in the heat treatment c. In order to render the precipitate X fine, a prolonged heat treatment at 350 to 550°C is required. In order to obtain a uniform recrystallized structure at the temperature, it is desirable to perform the cold-working between the heat treatment d and the heat treatment c at a working ratio of 40 to 80%, preferably 50 to 70%. When the working ratio is excessively high, a working crack occurs. When the working ratio is excessively low, recrystallization is not completed in the heat treatment c, and therefore a working crack occurs by a cold-working after the heat treatment c.

The material, which has been subjected to the heat treatment c, is subjected to a cold-rolling at a working ratio of 30 to 80%. Then, the resultant is subjected to a heat treatment b at 300 to 550°C for 10 to 120 seconds, to obtain a structure with an average crystal grain diameter of 1 to 15 µm. The structure is obtained as a result of recrystallization of a part or all of the original structure. Subsequently, a cold-rolling a is performed at a working ratio of 40 to 70%, and then a heat treatment a is performed at 300 to 550°C for 5 to 200 seconds. In the heat treatment a, it is desirable to adjust a heating rate and a cooling rate to be 40°C/second. The motive power for recrystallization in the heat treatment a is stored by the cold-rolling a, and a structure with a crystal grain diameter of 1 to 2 µm is obtained by the heat treatment a.
After the final cold-rolling is performed, a distortion-removing heat treatment is performed at 150 to 250°C for 0.5 hour. Each of the heat treatments a and b is a short-time annealing. The precipitates X and Y which were precipitated by the heat treatments c and d do not substantially vary in the distribution states by the heat treatments a and b.
Among the above-mentioned alloy manufacturing conditions, the conditions of the heat treatments d, c, b, and a and the cold-rolling a, and the like, besides the alloy composition, can adjust the crystal grain diameter, and the size and generation density of the nanometer-size precipitates X and Y, as specified in the present invention. The target copper alloy can be obtained by specifying these conditions as mentioned above.

There is no limitation on the use of the copper alloy of the present invention, and, for example, the copper alloy of the present invention can be used in preparing electronic and electric instrument component such as a connector, a terminal, a relay, a switch, and also a lead frame.

### EXAMPLES

The present invention will be described in more detail based on examples given below, but the invention is not meant to be limited by these.

Alloys shown in Examples were manufactured as follows.
An alloy including Sn, whose amount is described in each Example, 0.07 mass% of P, other addition elements, and the balance of Cu were dissolved in a high frequency melting furnace. DC casting of the resultant was performed at a cooling rate of 10 to 30°C/second, giving an ingot 30 mm in thickness, 100 mm in width, and 150 mm in length.
The ingot was subjected to a homogenizing heat treatment at 800°C for 1 hour and slowly cooled, and then the both sides were subjected to scalping, to remove an oxide film. Subsequently, a cold-rolling was performed, and a heat treatment d was performed at 550 to 750°C for 1 to 10 hours in an inert gas atmosphere, followed by slow cooling. Further, the resultant was cold-rolled at a rolling rate of 40% to 80%, to form a sheet material of 2 mm in thickness. Then, a heat treatment c was performed at 350 to 550°C for 1 to 10 hours in an inert gas atmosphere, and a structure with an average crystal grain diameter of 5 to 20 µm was obtained.
The material, which had been subjected to the heat treatment c, was subjected to a cold-rolling at a working ratio of 30 to 80%. Then, a resultant was subjected to a heat treatment b at 300 to 550°C for 10 to 120 seconds. The sheet material having a structure with an average crystal grain diameter of 1 to 15 µm, which had been subjected to the heat treatment b, was subjected to a cold-rolling a at a working ratio of 40 to 70%. Then, a heat treatment a was performed at 300 to 550°C for 5 to 200 seconds. The heat treatment a was performed at a heating rate of 40°C/second and a cooling rate of 40°C/second. Thereafter, a final cold-rolling was performed, and then a distortion-removing heat treatment was performed at 150 to 250°C for 0.5 hour.

Each sheet material thus obtained (sample material) was evaluated for the following properties. Each evaluation item was measured as follows. a. Mechanical properties (tensile strength, TS; 0.2% yield strength or 0.2%-proof stress, YS)
Three test pieces of JIS-13B, which were cut in parallel to the rolling direction, were evaluated according to JIS-Z2241, and each of these properties was expressed as an average value (MPa) of the three evaluation results. b. Bending property
A sheet material was cut out into a size of width 10 mm and length 25 mm. The resultant sheet material was subjected to W(90°)-bent at a bending radius R=0. Whether cracks were occurred or not at the bent portion, was observed with the naked eye through observation with an optical microscope of 50 times magnification, and the bent sites were observed with a scanning electron microscope to examine whether cracks were occurred or not. The test piece extraction direction was set to G.W. (the bending axis perpendicular to the rolling direction) and to B.W (the bending axis parallel to the rolling direction). "○" denotes that no crack was observed and "x" denotes that a crack was observed.

### c. Average crystal grain diameter

In a cross section parallel to the thickness direction of the sheet material and also parallel to the final cold-rolling direction (the final plastic-working direction), the crystal grain diameters were measured in the two directions: the direction parallel to the final cold-rolling direction and the direction perpendicular to the final cold-rolling direction. The larger measured values were classified as long diameters and the smaller measured values were classified as short diameters. The average value of the each four values of the long diameters and the short diameters was rounded to an integral multiple of 0.005 mm. According to the cutting method (JIS-H0501), etching was performed after the cross section of the sample material was mirror-surface polished. The resultant was photographed with a scanning electron microscope with a 1000-fold magnification, and a line segment with a length of 200 mm was drawn on the resultant photograph. Then, the number n of crystal grains cut with the line segment was counted to determine a crystal grain diameter from the following formula: 200 mm /(n×1000). When the number of crystal grains cut with the 200 mm line segment was less than 20, the crystal grains were photographed with a 500-fold magnification, and, then, the number n of crystal grains on the line segment with a length of 200 mm was counted to determine a crystal grain diameter from the following formula: 200 mm / (n × 500).

### d. Size and Density of Second Phase Precipitate

The sample was punched out into a shape of a disc of diameter 3 mm, and the resultant was subjected to thin-film-polishing by using a twinjet polishing method. Photographs (5,000 to 500,000 times magnification) of the resultant sample were taken at 3 arbitrary positions with a transmission electron microscope at an accelerating voltage of 300 kV, and the grain size and the density of the precipitate were measured on the photographs. When measurement of the grain size and the density of the precipitate were carried out, the number of grains was measured at n = 10 (n represents the number of viewing fields for observation) thereby to eliminate the localized bias on the numbers. The numbers were calculated into numbers per unit area (particles/mm²).

### e. Stress relaxation resistance (SR)

According to the method of Electronics Materials Manufacturers Association of Japan Standard (EMAS-3003), the stress relaxation ratio was determined and evaluated. Fig. 1 is an explanatory view illustrating the test method of stress relaxation property. As shown in Fig. 1 (a), to a test piece 1 whose one end was fixed to a test stand 3, a support stand 2 was attached to the other end of the test piece, to apply a deflection δ₀ (stress load equivalent to 80% of 0.2%-proof stress). After heating at 150°C for 1000 hours under such a state, the support stand 2 was removed as shown in Fig. 1 (b), and then a permanent deflection δt = Ht - H₁, which remained in the test piece 1, was measured (H₁ shows a case where no deflection was produced).
The stress relaxation ratio (%) was calculated by substituting the above δ₀ and δt in the formula (δt /δ₀) × 100. The alloy is considered to be excellent as the stress relaxation ratio is smaller.

### (Examples 1 to 3, Comparative Examples 1 to 12)

A sheet material was manufactured under the above-mentioned conditions using an alloy including 8.0 mass% of Sn, 0.16 mass% in total of Fe and Ni, 0.07 mass% of P, and the balance of Cu and unavoidable impurities. The sheet material was evaluated for the properties. Note that, only in Comparative Example 6, use was made of an alloy including 8.0 mass% of Sn, 0.07 mass% of P, and the balance of Cu and unavoidable impurities.
In Comparative Examples, the same manufacturing procedure as in the above-mentioned Examples was conducted, except for the following changes: in Comparative Example 1, the heat treatment c was performed at 650°C for 2 hours; in Comparative Example 2, the heat treatment d was performed at 800°C for 1 hour; in Comparative Example 3, the heat treatment a was performed at 280°C for 20 seconds; in Comparative Example 4, the heat treatment a was performed at 620°C for 20 seconds; in Comparative Example 5, the heat treatment a was performed at 580°C for 20 seconds; in Comparative Example 7, the heat treatment d was performed at 800°C for 8 hours; in Comparative Example 8, the heat treatment c was performed at 400°C for 2 hours; in Comparative Example 9, the heat treatment c was performed at 600°C for 8 hours; in Comparative Example 10, the heat treatment c was performed at 280°C for 8 hours; in Comparative Example 11, the heat treatment d was performed at 850°C for 2 hours; and in Comparative Example 12, the heat treatment c was performed at 750°C for 2 hours.
The results are shown in Table 1.

**Table 1**

| | Precipitate X | | Precipitate Y | | Crystal grain diameter µm | 0.2%-proof stress MPa | Tensile strength MPa | Bending property | | Stress relaxation ratio % |
|---|---|---|---|---|---|---|---|---|---|---|
| | Size nm | Density Particles/mm² | Size nm | Density Particles/mm² | | | | GW | BW | |
| Example 1 | 30 | 1.0×10⁸ | 100 | 1.0×10⁶ | 1.1 | 699 | 728 | ○ | ○ | 34 |
| Example 2 | 30 | 1.0×10⁹ | 115 | 1.0×10⁶ | 1.3 | 672 | 717 | ○ | ○ | 33 |
| Example 3 | 35 | 1.0×10⁸ | 85 | 1.0×10⁷ | 1.5 | 651 | 708 | ○ | ○ | 32 |
| Comparative example 1 | 35 | 1.0×10⁴ | 100 | 1.0×10⁶ | 1.5 | 651 | 708 | ○ | ○ | 45 |
| Comparative example 2 | 30 | 1.0×10⁸ | 100 | 1.0×10³ | 2.3 | 608 | 692 | ○ | ○ | 28 |
| Comparative example 3 | 30 | 1.0×10⁸ | 100 | 1.0×10⁶ | 0.8 | 736 | 752 | X | X | 35 |
| Comparative example 4 | 30 | 1.0×10⁸ | 100 | 1.0×10⁶ | 3.5 | 553 | 667 | ○ | ○ | 25 |
| Comparative example 5 | 30 | 1.0×10⁸ | 100 | 1.0×10⁶ | 2.5 | 634 | 701 | X | X | 28 |
| Comparative example 6 | - | - | - | - | 1.5 | 651 | 708 | ○ | ○ | 50 |
| Comparative example 7 | 30 | 1.0×10⁸ | 600 | 1.0×10³ | 2.5 | 592 | 680 | ○ | ○ | 27 |
| Comparative example 8 | 30 | 1.0×10⁸ | 45 | 1.0×10⁹ | 2.4 | 599 | 688 | ○ | ○ | 28 |
| Comparative example 9 | 60 | 1.0×10⁴ | 115 | 1.0×10⁶ | 1.5 | 650 | 710 | ○ | ○ | 47 |
| Comparative example 10 | 0.3 | 1.0×10¹² | 85 | 1.0×10⁷ | 1.5 | 655 | 713 | ○ | ○ | 48 |
| Comparative example 11 | 30 | 1.0×10⁹ | **-** | - | 2.4 | 598 | 688 | ○ | ○ | 28 |
| Comparative example 12 | - | - | 85 | 1.0×10⁷ | 1.5 | 650 | 700 | ○ | ○ | 49 |

As is clear from Table 1, Examples 1 to 3 according to the present invention were excellent in all of 0.2%-proof stress, tensile strength, bending property, and stress relaxation resistance.
However, in Comparative Example 1, because the density of the precipitate X was low, the stress relaxation resistance was poor. In Comparative Example 2, because the density of the precipitate Y was low, the crystal grain diameter became large and 0.2%-proof stress and tensile strength were poor. In Comparative Example 3, because the crystal grain diameter was small, the bending property was poor. In Comparative Example 4, because the crystal grain diameter was large, favorable mechanical strength and bending property were not attained at the same time, and the 0.2%-proof stress and tensile strength were poor. In Comparative Example 5, because the crystal grain diameter was large, favorable mechanical strength and bending property were not attained at the same time, and the bending property was poor. In Comparative Example 6, because no precipitate was generated, the stress relaxation resistance was poor. In Comparative Example 7, because the precipitate Y was large and had a low density, the crystal grain diameter became large and the 0.2%-proof stress and tensile strength were poor. In Comparative Example 8, because the precipitate Y was small and had a high density, the crystal grain diameter became large and the 0.2%-proof stress and tensile strength were poor. In Comparative Example 9, because the precipitate X was large and had a low density, the stress relaxation resistance was poor. In Comparative Example 10, because the precipitate X was small and had a high density, the stress relaxation resistance was poor. In Comparative Example 11, because no precipitate Y was generated, the crystal grain diameter became large and the 0.2%-proof stress and tensile strength were poor. In Comparative Example 12, because no precipitate X was generated, the stress relaxation resistance was poor.

### (Examples 4 to 6, Comparative Examples 13 to 24)

A sheet material was manufactured under the above-mentioned conditions using an alloy including 10.0 mass% of Sn, 0.16 mass% in total of Fe and Ni, 0.07 mass% of P, and the balance of Cu and unavoidable impurities. The sheet material was evaluated for the properties. Note that, only in Comparative Example 18, use was made of an alloy including 10.0 mass% of Sn, 0.07 mass% of P, and the balance of Cu and unavoidable impurities.
In Comparative Examples, the same manufacturing procedure as in the above-mentioned Examples was conducted, except for the following changes: in Comparative Example 13, the heat treatment c was performed at 650°C for 2 hours; in Comparative Example 14, the heat treatment d was performed at 800°C for 1 hour; in Comparative Example 15, the heat treatment a was performed at 280°C for 20 seconds; in Comparative Example 16, the heat treatment a was performed at 620°C for 20 seconds; in Comparative Example 17, the heat treatment a was performed at 580°C for 20 seconds; in Comparative Example 19, the heat treatment d was performed at 800°C for 8 hours; in Comparative Example 20, the heat treatment c was performed at 400°C for 2 hours; in Comparative Example 21, the heat treatment c was performed at 600°C for 8 hours; in Comparative Example 22, the heat treatment c was performed at 280°C for 8 hours; in Comparative Example 23, the heat treatment d was performed at 850°C for 2 hours; and in Comparative Example 24, the heat treatment c was performed at 750°C for 2 hours.
The results are shown in Table 2.

**Table 2**

| | Precipitate X | | Precipitate Y | | Crystal grain diameter µm | 0.2%-proof stress MPa | Tensile strength MPa | Bending property | | Stress relaxation ratio % |
|---|---|---|---|---|---|---|---|---|---|---|
| | Size nm | Density Particles/mm² | Size nm | Density Particles/mm² | | | | GW | BW | |
| Example 4 | 30 | 1.0×10⁹ | 115 | 1.0×10⁶ | 1.2 | 736 | 790 | ○ | ○ | 33 |
| Example 5 | 30 | 1.0× 10⁸ | 100 | 1.0× 10⁶ | 1.4 | 710 | 780 | ○ | ○ | 32 |
| Example 6 | 30 | 1.0×10⁸ | 85 | 1.0×10⁷ | 1.5 | 702 | 776 | ○ | ○ | 31 |
| Comparative example 13 | 30 | 1.0×10⁴ | 100 | 1.0×10⁶ | 1.5 | 699 | 776 | ○ | ○ | 46 |
| Comparative example 14 | 30 | 1.0×10⁸ | 100 | 1.0×10³ | 2.4 | 640 | 750 | ○ | ○ | 27 |
| Comparative example 15 | 30 | 1.0×10⁸ | 100 | 1.0×10⁶ | 0.8 | 806 | 821 | X | X | 34 |
| Comparative example 16 | 30 | 1.0×10⁸ | 100 | 1.0×10⁶ | 3.5 | 589 | 734 | ○ | ○ | 24 |
| Comparative example 17 | 30 | 1.0×10⁸ | 100 | 1.0×10⁶ | 2.5 | 680 | 768 | X | X | 27 |
| Comparative example 18 | - | - | - | - | 1.5 | 699 | 776 | ○ | ○ | 49 |
| Comparative example 19 | 30 | 1.0×10⁸ | 600 | 1.0×10³ | 2.5 | 635 | 750 | ○ | ○ | 27 |
| Comparative example 20 | 20 | 1.0×10⁸ | 45 | 1.0×10⁹ | 2.3 | 645 | 755 | ○ | ○ | 27 |
| Comparative example 21 | 60 | 1.0×10⁴ | 115 | 1.0×10⁶ | 1.5 | 698 | 775 | ○ | ○ | 47 |
| Comparative example 22 | 0.3 | 1.0×10¹² | 85 | 1.0×10⁷ | 1.5 | 695 | 770 | ○ | ○ | 48 |
| Comparative example 23 | 30 | 1.0 × 10⁹ | - | - | 2.7 | 628 | 748 | ○ | ○ | 25 |
| Comparative example 24 | - | - | 85 | 1.0×10⁷ | 1.5 | 696 | 772 | ○ | ○ | 48 |

As is clear from Table 2, Examples 4 to 6 according to the present invention showed excellent 0.2%-proof stress, tensile strength, bending property, and stress relaxation resistance.
However, in Comparative Example 13, because the density of the precipitate X was low, the stress relaxation resistance was poor. In Comparative Example 14, because the density of the precipitate Y was low, the crystal grain diameter became large and 0.2%-proof stress and tensile strength were poor. In Comparative Example 15, because the crystal grain diameter was small, the bending property was poor. In Comparative Example 16, because the crystal grain diameter was large, favorable mechanical strength and bending property were not attained at the same time, and the 0.2%-proof stress and tensile strength were poor. In Comparative Example 17, because the crystal grain diameter was large, favorable mechanical strength and bending property were not attained at the same time, and the bending property was poor. In Comparative Example 18, because no precipitate was generated, the stress relaxation resistance was poor. In Comparative Example 19, because the precipitate Y was large and had a low density, the crystal grain diameter became large and the 0.2%-proof stress and tensile strength were poor. In Comparative Example 20, because the precipitate Y was small and had a high density, the crystal grain diameter became large and the 0.2%-proof stress and tensile strength were poor. In Comparative Example 21, because the precipitate X was large and had a low density, the stress relaxation resistance was poor. In Comparative Example 22, because the precipitate X was small and had a high density, the stress relaxation resistance was poor. In Comparative Example 23, because no precipitate Y was generated, the crystal grain diameter became large and the 0.2%-proof stress and tensile strength were poor. In Comparative Example 24, because no precipitate X was generated, the stress relaxation resistance was poor.

### (Examples 7 to 9, Comparative Examples 25 to 31)

A sheet material was manufactured under the above-mentioned conditions using an alloy including 12.0 mass% of Sn, 0.16 mass% in total of Fe and Ni, 0.07 mass% of P, and the balance of Cu and unavoidable impurities. The sheet material was evaluated for the properties. Note that, only in Comparative Example 29, use was made of an alloy including 12.0 mass% of Sn, 0.07 mass% of P, and the balance of Cu and unavoidable impurities.
In Comparative Examples, the same manufacturing procedure as in the above-mentioned Examples was conducted, except for the following changes: in Comparative Example 25, the heat treatment c was performed at 650°C for 2 hours; in Comparative Example 26, the heat treatment a was performed at 280°C for 20 seconds; in Comparative Example 27, the heat treatment a was performed at 620°C for 20 seconds; in Comparative Example 28, the heat treatment a was performed at 580°C for 20 seconds; in Comparative Example 30, the heat treatment d was performed at 850°C for 2 hours; in Comparative Example 31, the heat treatment c was performed at 750°C for 2 hours.
The results are shown in Table 3.

**Table 3**

| | Precipitate X | | Precipitate Y | | Crystal grain diameter µm | 0.2%-proof stress MPa | Tensile strength MPa | Bending property | | Stress relaxation ratio % |
|---|---|---|---|---|---|---|---|---|---|---|
| | Size nm | Density Particles/mm² | Size nm | Density Particles/mm² | | | | GW | BW | |
| Example 7 | 35 | 1.0×10⁷ | 100 | 1.0×10⁶ | 1.3 | 740 | 810 | ○ | ○ | 33 |
| Example 8 | 30 | 1.0×10⁸ | 115 | 1.0×10⁵ | 1.5 | 715 | 800 | ○ | ○ | 31 |
| Example 9 | 25 | 1.0×10⁹ | 115 | 1.0× 10⁶ | 1.7 | 695 | 790 | ○ | ○ | 29 |
| Comparative example 25 | 30 | 1.0×10⁴ | 100 | 1.0×10⁶ | 1.5 | 706 | 790 | ○ | ○ | 46 |
| Comparative example 26 | 30 | 1.0×10⁸ | 100 | 1.0×10⁶ | 0.8 | 824 | 835 | X | X | 34 |
| Comparative example 27 | 30 | 1.0×10⁸ | 100 | 1.0 × 10⁶ | 3.5 | 596 | 748 | O | O | 23 |
| Comparative example 28 | 30 | 1.0×10⁸ | 100 | 1.0×10⁶ | 2.5 | 687 | 782 | X | X | 26 |
| Comparative example 29 | - | - | - | - | 1.5 | 706 | 790 | ○ | ○ | 49 |
| Comparative example 30 | 35 | 1.0×10⁸ | - | - | 2.7 | 658 | 765 | ○ | ○ | 27 |
| Comparative example 31 | - | - | 85 | 1.0×10⁷ | 1.5 | 710 | 795 | ○ | ○ | 49 |

As is clear from Table 3, Examples 7 to 9 according to the present invention showed excellent 0.2%-proof stress, tensile strength, bending property, and stress relaxation resistance.
However, in Comparative Example 25, because the density of the precipitate X was low, the stress relaxation resistance was poor. In Comparative Example 26, because the crystal grain diameter was small, the bending property was poor. In Comparative Example 27, because the crystal grain diameter was large, favorable mechanical strength and bending property were not attained at the same time, and the 0.2%-proof stress and tensile strength were poor. In Comparative Example 28, because the crystal grain diameter was large, favorable mechanical strength and bending property were not attained at the same time, and the bending property was poor. In Comparative Example 29, because no precipitate was generated, the stress relaxation resistance was poor. In Comparative Example 30, because no precipitate Y was generated, the crystal grain diameter became large and the 0.2%-proof stress and tensile strength were poor. In Comparative Example 31, because no precipitate X was generated, the stress relaxation resistance was poor.

### (Examples 10 and 11, Comparative Examples 32 to 37)

A sheet material was manufactured under the above-mentioned conditions using an alloy including 6.0 mass% of Sn, 0.16 mass% in total of Fe and Ni, 0.07 mass% of P, and the balance of Cu and unavoidable impurities. The sheet material was evaluated for the properties. Note that, only in Comparative Example 35, use was made of an alloy including 6.0 mass% of Sn, 0.07 mass% of P, and the balance of Cu and unavoidable impurities.
In Comparative Examples, the same manufacturing procedure as in the above-mentioned Examples was conducted, except for the following changes: in Comparative Example 32, the heat treatment c was performed at 650°C for 2 hours; in Comparative Example 33, the heat treatment a was performed at 620°C for 20 seconds; in Comparative Example 34, the heat treatment a was performed at 580°C for 20 seconds; in Comparative Example 36, the heat treatment d was performed at 850°C for 2 hours; in Comparative Example 37, the heat treatment c was performed at 750°C for 2 hours.
The results are shown in Table 4.

**Table 4**

| | Precipitate X | | Precipitate Y | | Crystal grain diameter µm | 0.2%-proof stress MPa | Tensile strength MPa | Bending property | | Stress relaxation ratio % |
|---|---|---|---|---|---|---|---|---|---|---|
| | Size nm | Density Partlcles/mm² | Size nm | Density Partides/mm² | | | | GW | BW | |
| Example 10 | 35 | 1.0 × 10⁸ | 115 | 1.0 × 10⁵ | 1.5 | 625 | 680 | ○ | ○ | 34 |
| Example 11 | 35 | 1.0 × 10⁸ | 100 | 1.0 × 10⁶ | 1.7 | 602 | 665 | ○ | ○ | 33 |
| Comparative example 32 | 35 | 1.0×10⁴ | 100 | 1.0×10⁶ | 1.5 | 625 | 680 | ○ | ○ | 46 |
| Comparative example 33 | 30 | 1.0×10⁸ | 100 | 1.0×10⁶ | 3.5 | 522 | 632 | ○ | ○ | 29 |
| Comparative example 34 | 30 | 1.0×10⁸ | 100 | 1.0×10⁶ | 2.5 | 598 | 663 | X | X | 32 |
| Comparative example 35 | - | - | - | - | 1.5 | 625 | 680 | ○ | ○ | 48 |
| Comparative example 36 | 35 | 1.0×10⁸ | - | - | 2.7 | 575 | 648 | ○ | ○ | 27 |
| Comparative example 37 | - | - | 85 | 1.0×10⁷ | 1.5 | 620 | 672 | ○ | ○ | 49 |

As is clear from Table 4, Examples 10 and 11 according to the present invention showed excellent 0.2%-proof stress, tensile strength, bending property, and stress relaxation resistance.
However, in Comparative Example 32, because the density of the precipitate X was low, the stress relaxation resistance was poor. In Comparative Example 33, because the crystal grain diameter was large, favorable mechanical strength and bending property were not attained at the same time, and the 0.2%-proof stress and tensile strength were poor. In Comparative Example 34, because the crystal grain diameter was large, favorable mechanical strength and bending property were not attained at the same time, and the bending property was poor. In Comparative Example 35, because no precipitate was generated, the stress relaxation resistance was poor. In Comparative Example 36, because no precipitate Y was generated, the crystal grain diameter became large and the 0.2%-proof stress and tensile strength were poor. In Comparative Example 37, because no precipitate X was generated, the stress relaxation resistance was poor.

### (Examples 12 to 32, Comparative Example 38)

A sheet material was manufactured under the above-mentioned conditions using an alloy including 8.0 mass% of Sn, 0.07 mass% of P, the elements shown in Table 5, and the balance of Cu and unavoidable impurities. The sheet material was evaluated for the properties. Note that, in Comparative Example 38, the same manufacturing procedure as in the Example was conducted, using an alloy of 8.0 mass% of Sn, 0.07 mass% of P, and the balance of Cu and unavoidable impurities.
The results are shown in Table 5.

**Table 5**

| | Addition element mass% | Precipitate X | | | Precipitate Y | | | 0.2%-proof stress MPa | Tensile strength MPa | Bending property | | Stress relaxation ratio % |
|---|---|---|---|---|---|---|---|---|---|---|---|---|
| | | Composition | Size nm | Density Particles/mm² | Composition | Size nm | Density Particles/mm² | | | GW | BW | |
| Example 12 | Mn:0.15 | Mn-P | 30 | 1.0×10⁸ | Mn-P | 125 | 1.0×10⁶ | 677 | 722 | ○ | ○ | 31 |
| Example 13 | Mg:0.1 | Mg-P | 35 | 1.0×10⁸ | Mg-P | 120 | 1.0×10⁶ | 670 | 720 | ○ | ○ | 31 |
| Example 14 | Cr:0.15 | Cr-P | 25 | 1.0×10⁸ | Cr-P | 115 | 1.0×10⁶ | 668 | 715 | ○ | ○ | 33 |
| Example 15 | W:0.3 | W-P | 35 | 1.0×10⁸ | W-P | 120 | 1.0×10⁶ | 675 | 721 | ○ | ○ | 34 |
| Example 16 | Co:0.15 | Co-P | 25 | 1.0×10⁸ | Co-P | 120 | 1.0×10⁶ | 677 | 722 | ○ | ○ | 30 |
| Example 17 | Cr:0.2, Si:0.1 | Cr-Si | 30 | 1.0×10⁸ | Cr-Si | 125 | 1.0×10⁶ | 668 | 717 | ○ | ○ | 32 |
| Example 18 | Ni:0.15, Si:0.1 | Ni-Si-P | 30 | 1.0×10⁸ | Ni-Si-P | 115 | 1.0×10⁶ | 666 | 718 | ○ | ○ | 33 |
| Example 19 | Fe:0.15, B:0.05 | Fe-B-P | 25 | 1.0×10⁸ | Fe-B-P | 120 | 1.0×10⁶ | 670 | 720 | ○ | ○ | 32 |
| Example 20 | Mn:0.1, Co:0.1 | Mn-Co-P | 35 | 1.0×10⁸ | Mn-Co-P | 120 | 1.0×10⁶ | 678 | 715 | ○ | ○ | 31 |
| Example 21 | Cr:0.1, Fe:0.1 | Cr-Fe-P | 30 | 1.0×10⁸ | Cr-Fe-P | 125 | 1.0×10⁶ | 665 | 721 | ○ | ○ | 34 |
| Example 22 | Ni:0.1, Mn:0.1 | Ni-Mn-P | 35 | 1.0×10⁸ | Ni-Mn-P | 120 | 1.0 × 10⁶ | 660 | 722 | ○ | ○ | 34 |
| Example 23 | Ca:0.1, Si:0.1 | Ca-Si | 25 | 1.0×10⁸ | Ca-Si | 115 | 1.0×10⁶ | 665 | 717 | ○ | ○ | 33 |
| Example 24 | Ni:0.15, Si:0.1 | Ni-Si | 35 | 1.0×10⁸ | Ni-Si | 120 | 1.0×10⁶ | 668 | 718 | ○ | ○ | 34 |
| Example 25 | Zr:0.05 | Cu-Zr | 25 | 1.0×10⁸ | Cu-Zr | 120 | 1.0×10⁶ | 666 | 720 | ○ | ○ | 31 |
| Example 26 | Ti:0.1 | Cu-Ti | 30 | 1.0×10⁸ | Cu-Ti | 125 | 1.0×10⁶ | 670 | 715 | ○ | ○ | 32 |
| Example 27 | Mn:0.1, Si:0.1 | Mn-Si | 30 | 1.0×10⁸ | Mn-Si | 115 | 1.0×10⁶ | 678 | 721 | ○ | ○ | 33 |
| Example 28 | Ni:0.1, B:0.05 | Ni-B | 25 | 1.0×10⁸ | Ni-B | 120 | 1.0×10⁶ | 665 | 722 | ○ | ○ | 30 |
| Example 29 | Fe:0.15, Ti:0.1 | Fe-Ti | 35 | 1.0×10⁸ | Fe-Ti | 120 | 1.0×10⁶ | 660 | 717 | ○ | ○ | 31 |
| Example 30 | Ni:0.1, Ti:0.1 | Ni-Ti | 30 | 1.0×10⁸ | Ni-Ti | 115 | 1.0×10⁶ | 665 | 718 | ○ | ○ | 32 |
| Example 31 | Co:0.1, Si:0.1 | Co-Si | 25 | 1.0×10⁸ | Co-Si | 120 | 1.0×10⁶ | 678 | 721 | ○ | ○ | 33 |
| Example 32 | Ni:0.1, Al:0.1 | Ni-Al | 35 | 1.0×10⁸ | Ni-Al | 120 | 1.0×10⁶ | 665 | 722 | ○ | ○ | 33 |
| Comparative example 38 | - | - | - | - | - | - | - | 652 | 705 | X | X | 51 |

As is clear from Table 5, Examples 12 to 32 according to the present invention showed excellent 0.2%-proof stress, tensile strength, bending property, and stress relaxation resistance.
However, In Comparative Example 38, because no precipitates X and Y were generated and the crystal grain diameter was large, favorable mechanical strength and bending property were not attained at the same time, and bending property was poor. Further, stress relaxation resistance was poor.

### (Examples 33 to 44, Comparative Examples 39 to 41)

A sheet material was manufactured under the above-mentioned manufacturing conditions, except that the working ratio of the cold-working a and the heat treatment a were changed as shown in Table 6, using an alloy including 8.0 mass% of Sn, 0.16 mass% in total of Fe and Ni, 0.07 mass% of P, and the balance of Cu and unavoidable impurities. The sheet material was evaluated for the properties. The results are shown in Table 6.

**Table 6**

| | Heat treatment b Grain diameter µm | Cold-working a Working ratio % | Heat treatment a | | | | Crystal grain diameter µm | 0.2%-proof stress MPa | Tensile strength MPa | Bending property | | Stress relaxation ratio % |
|---|---|---|---|---|---|---|---|---|---|---|---|---|
| | | | Heating rate °C/sec | Temp. °C | Time sec | Cooling rate °C/sec | | | | GW | BW | |
| Example 33 | 5 | 40 | 40 | 445 | 20 | 40 | 1.9 | 630 | 702 | ○ | ○ | 30 |
| Example 34 | 5 | 50 | 40 | 425 | 20 | 40 | 1.7 | 644 | 708 | ○ | ○ | 31 |
| Example 35 | 5 | 60 | 40 | 420 | 20 | 40 | 1.4 | 673 | 719 | ○ | ○ | 32 |
| Example 36 | 5 | 70 | 40 | 415 | 20 | 40 | 1.2 | 697 | 729 | ○ | ○ | 33 |
| Example 37 | 1.5 | 60 | 40 | 415 | 40 | 40 | 1 | 727 | 742 | ○ | ○ | 35 |
| Example 38 | 1 | 60 | 40 | 415 | 40 | 40 | 1.1 | 711 | 735 | ○ | ○ | 34 |
| Example 39 | 2 | 60 | 40 | 415 | 40 | 40 | 1.2 | 697 | 729 | ○ | ○ | 33 |
| Example 40 | 4 | 60 | 40 | 415 | 40 | 40 | 1.2 | 697 | 729 | ○ | ○ | 33 |
| Example 41 | 6 | 60 | 40 | 415 | 40 | 40 | 1.3 | 684 | 724 | ○ | ○ | 33 |
| Example 42 | 8 | 60 | 40 | 415 | 40 | 40 | 1.4 | 673 | 719 | ○ | ○ | 32 |
| Example 43 | 10 | 60 | 40 | 415 | 40 | 40 | 1.4 | 673 | 719 | ○ | ○ | 32 |
| Example 44 | 15 | 60 | 40 | 415 | 40 | 40 | 1.5 | 663 | 715 | ○ | ○ | 32 |
| Comparative example 39 | 5 | 30 | 40 | 460 | 40 | 40 | 3.2 | 570 | 675 | ○ | ○ | 31 |
| Comparative example 40 | 5 | 80 | The production was stopped and not completed due to occurrence of cracks during cold-working a. | | | | | | | | | |
| Comparative example 41 | 20 | 60 | 40 | 415 | 20 | 40 | 1.6 | 654 | 711 | x | x | 30 |

As is clear from Table 6, Examples 33 to 34 according to the present invention showed excellent 0.2%-proof stress, tensile strength, bending property, and stress relaxation resistance.
However, in Comparative Example 39, because the working ratio of the cold-working a was low, the 0.2%-proof stress and tensile strength were poor. In Comparative Example 40, because the working ratio at the cold-working a was high, cracks were generated during the working, and thus, the manufacturing process was stopped. In Comparative Example 41, because the crystal grain diameter of the sheet material before being subjected to the heat treatment b was large, the bending property was poor.

### INDUSTRIAL APPLICABILITY

The copper alloy of the present invention is excellent in mechanical strength and bending property and is suitable for a connector and terminal for use in electronic and electric instruments or wirings in automobiles. Further, the method of manufacturing the copper alloy of the present invention is suitable as a method of manufacturing the above-mentioned copper alloy.
Having described our invention as related to the present embodiments, it is our intention that the invention not be limited by any of the details of the description, unless otherwise specified, but rather be construed broadly within its spirit and scope as set out in the accompanying claims.

## Claims

1. A copper alloy, comprising Sn 3.0 to 13.0 mass%, with the balance being Cu and unavoidable impurities, which copper alloy contains a crystal grain whose diameter is 1.0 to 2.0 µm,
wherein the copper alloy has a precipitate X having a diameter of 1 to 50 nm and a density of 10⁶ to 10¹⁰ per mm², and a precipitate Y having a diameter of 50 to 500 nm and a density of 10⁴ to 10⁸ per mm².

2. The copper alloy according to claim 1, wherein the precipitates X and Y each are composed of P and at least one element among Mn, Mg, Cr, W, Co, B, Ni, Fe, Ca, Si, Cu, Ti, Zr, and Al.

3. The copper alloy according to claim 1, wherein the precipitates X and Y each are composed of at least two elements among Mn, Mg, Cr, W, Co, B, Ni, Fe, Ca, Si, Cu, Ti, Zr, and Al.

4. The copper alloy according to claim 1, wherein the precipitates X and Y each are composed of Fe, Ni, and P.

5. An electronic and electric instrument part, comprising the copper alloy according to any one of the claims 1 to 4.

6. A method of producing the copper alloy according to any one of the claims 1 to 4, wherein the method comprises the steps of:
cold-working a recrystallized structure with an average crystal grain diameter of 1 to 15 µm at a working ratio of 40 to 70%; and
heating the resultant to obtain a recrystallized structure with a crystal grain diameter of 1 to 2 µm.
